# EUROPEAN PATENT APPLICATION

(11) **EP 4 637 299 A1**
(43) Date of publication of application: **22.10.2025**
(21) Application number: 25171761.7
(22) Date of filing: 22.04.2025
(51) Int. Cl.: H10F 10/165, H10F 10/166, H10F 71/00, H10F 77/30

(54) **SOLAR CELL AND METHOD FOR MANUFACTURING THE SAME**

(30) Priority: 19.04.2024 CN 202410485399; 08.05.2024 CN 202410563104; 27.08.2024 CN 202411184801; 26.09.2024 CN 202411352531
(71) Applicant: CSI Cells (YangZhou) Co., Ltd., Yangzhou, Jiangsu 225000 (CN); CSI Cells Co., Ltd., Suzhou, Jiangsu 215000 (CN)
(72) Inventor: YE, Xiaoya, Suzhou, 215000 (CN); CHEN, Haiyan, Suzhou, 215000 (CN); DENG, Weiwei, Suzhou, 215000 (CN)
(74) Representative: Grey, Ian Michael

(57) **Abstract**

The present invention provides a solar cell and a manufacturing method thereof. The solar cell includes a silicon substrate, a front electrode and a rear electrode. A rear surface of the silicon substrate has a grid line area and a non-grid line area. The rear electrode is disposed in the grid line area. The grid line area has a first passivated contact structure, which is sequentially stacked with a tunnel layer, at least one first doped polysilicon layer, at least one isolation layer, and a second doped polysilicon layer. The passivated contact structure of the present invention has different film layers and thicknesses in the grid line area and the non-grid line area. The grid line area has a four-layer structure consisting of a tunnel layer, a first doped polysilicon layer, an isolation layer, and a second doped polysilicon layer. The four-layer structure has a large thickness and two doped polysilicon layers, which can prevent the doped polysilicon layers from being penetrated and the underlying tunnel oxide layer from being damaged during the sintering of the grid line paste, thus ensuring the field passivation effect. In contrast, the non-grid line area only includes a tunnel layer and a first doped polysilicon layer. Compared with the grid line area, its thickness is greatly reduced, which reduces the parasitic absorption of backlight and improves the photoelectric efficiency.

## Description

### CROSS-REFERENCE TO RELATED APPLICATIONS

This application claims priority to the following Chinese patent applications: filed on April 19, 2024, under application number 202410485399.0; filed on May 8, 2024, under application number 202410563104.7; filed on August 27, 2024, under application number 202411184801.8; and filed on September 26, 2024, under application number 202411352531.7. The entire contents of these patent applications are incorporated by reference into the present application.

### FIELD

The invention relates to the field of photovoltaics, and particularly to a solar cell and a method for manufacturing the same.

### BACKGROUND

TOPCon (Tunnel Oxide Passivated Contact) solar cells employ a passivated contact structure on the rear surface using a tunnel layer and a doped polysilicon layer. This structure achieves a field passivation effect, reduces contact resistance, and increases the open-circuit voltage and short-circuit current of the cells, thereby enhancing the cell conversion efficiency.

However, the thickness of the doped polysilicon layer on the rear surface ranges from 100 nm to 150 nm, which affects the light absorption on the rear surface light and further impacts the cell efficiency.

Hence, it is indeed necessary to provide an improved solar cell and a corresponding method to solve the above-mentioned technical problems.

### SUMMARY

The objective of the present invention is to provide a solar cell and a method for manufacturing the same. The solar cell improves the passivation effect on the rear surface, enhances light absorption efficiency, and achieves superior energy conversion efficiency with a streamlined fabrication process.

In order to achieve the above-mentioned object of the invention, the present invention provides a solar cell. The solar cell includes a silicon substrate having a front surface and a rear surface; a passivated contact structure located on the rear surface of the silicon substrate; and a rear electrode located on the passivated contact structure. The passivated contact structure includes a tunnel layer, a first doped polysilicon layer, an isolation layer, and a second doped polysilicon layer that are sequentially arranged on the rear surface of the silicon substrate. The isolation layer is configured in a non-continuous arrangement.

In an optional embodiment, the isolation layer comprises one or more of a silicon oxide layer, a silicon oxynitride layer, and a silicon carbide layer.

In an optional embodiment, a thickness of the tunnel layer ranges from 1 nm to 3 nm.

In an optional embodiment, a thickness of the isolation layer ranges from 0.5 nm to 3 nm.

In an optional embodiment, a thickness of the tunnel layer and a thickness of the isolation layer ranges from 1.5 nm to 2 nm.

In an optional embodiment, a thickness of the first doped polysilicon layer is less than or equal to a thickness of the second doped polysilicon layer.

In an optional embodiment, doping types of the first doped polysilicon layer and the second doped polysilicon layer are the same as that of the silicon substrate, and a doping concentration of the second doped polysilicon layer is greater than a doping concentration of the first doped polysilicon layer.

In an optional embodiment, a doping concentration of the first doped polysilicon layer is in the range of 1×10²⁰ cm⁻³ to 9×10²⁰ cm⁻³, and a doping concentration of the second doped polysilicon layer is in the range of 2×10²⁰ cm⁻³ to 3×10²¹ cm⁻³.

In an optional embodiment, the solar cell further includes a rear passivation layer and a rear anti-reflection layer that are sequentially arranged on a surface of the passivated contact structure facing away from the rear surface of the silicon substrate, and a front diffusion layer, wherein the rear electrode penetrates the rear anti-reflection layer and the rear passivation layer to contact the second doped polysilicon layer.

In an optional embodiment, the solar cell further includes a front passivation layer, a front anti-reflection layer, a front electrode that are sequentially arranged on the front surface of the silicon substrate, wherein the front electrode penetrates the front anti-reflection layer and the front passivation layer to contact the front diffusion layer.

In order to achieve the above-mentioned object of the invention, the present invention also provides a method for manufacturing a solar cell. The method includes: depositing a tunnel layer, a first doped amorphous silicon layer, an isolation layer, and a second doped amorphous silicon layer sequentially on a rear surface of a silicon substrate; forming a mask locally on the second doped amorphous silicon layer; converting the first doped amorphous silicon layer to a first doped polysilicon layer and the second doped amorphous silicon layer to a second doped polysilicon layer; removing the second doped polysilicon layer in the regions outside the mask; and removing the mask and part of the isolation layer to form a discontinuous isolation layer.

In an optional embodiment, the mask layer is preferably formed by laser processing in an oxygen atmosphere.

In order to achieve the above-mentioned object of the invention, the present invention further provides a method for manufacturing a solar cell. The method includes: providing a silicon substrate, the silicon substrate having a first surface and a second surface that are opposite to each other, the second surface comprising a first region and a second region; preparing a tunnel layer, a first phosphorus-doped amorphous silicon layer, an isolation layer, and a second phosphorus-doped amorphous silicon layer sequentially on the second surface of the silicon substrate; converting the first phosphorous-doped amorphous silicon layer to a first doped polysilicon layer and the second phosphorous-doped amorphous silicon layer to a second doped polysilicon layer; forming a mask layer on the surface of the second doped amorphous silicon layer in the first region; removing at least part of the second doped polysilicon layer in the second region and the mask layer in the first region, to retain the second doped polysilicon in the first region; and preparing an electrode in contact with the second doped polysilicon layer in the first region.

In an optional embodiment, the mask layer is an oxide layer.

In an optional embodiment, said removing at least part of the second doped polysilicon layer in the second region and the mask layer in the first region, to retain the second doped polysilicon in the first region includes: removing the entire second doped polysilicon layer on the second region using an alkaline solution, and removing the outermost isolation layer on the second region and the oxide layer on the first region.

In an optional embodiment, said removing at least part of the second doped polysilicon layer in the second region and the mask layer in the first region, to retain the second doped polysilicon in the first region includes: removing part of the second doped polysilicon layer on the second region using an alkaline solution, and removing the oxide layer on the first region using an acid solution.

In an optional embodiment, the tunnel layer is one or a combination of a silicon oxide layer and a silicon oxynitride layer, with a thickness ranging from 1 nm to 3 nm.

In an optional embodiment, the isolation layer is one or a combination of a silicon oxide layer, a silicon oxynitride layer, a silicon carbide layer, with a thickness ranging from 0.5 nm to 3 nm or 1.5 nm to 2nm.

In order to achieve the above-mentioned object of the invention, the present invention still provides a solar cell. The solar cells includes a silicon substrate and an electrode. The silicon substrate has a first surface and a second surface that are opposite to each other. The second surface includes a first region and a second region. A tunnel layer, at least one first doped layer, at least one isolation layer and a second doped layer are arranged on the second surface in the first region. A tunnel layer and at least one first doped layer are arranged on the second surface in the second region. The electrode is located in the first region and in contact with the second doped layer.

In an optional embodiment, the first region is provided with a tunnel layer, one first doped layer, one isolation layer, and a second doped layer, the second region is provided with a tunnel layer and one first doped layer.

In an optional embodiment, the first region is provided with a tunnel layer, one first doped layer, one isolation layer, and a second doped layer, the second region is provided with a tunnel layer, one first doped layer, one isolation layer, and a second doped layer, a thickness of the second doped layer on the second region is less than that of the second doped layer on the first region.

In an optional embodiment, the first region is provided with a tunnel layer, at least two first doped layers, at least two isolation layers stacked alternately, and a second doped layer, the second region is provided with a tunnel layer, at least two first doped layers and at least one isolation layer stacked alternately.

In an optional embodiment, the first region is provided with a tunnel layer, at least two first doped layers and at least two isolation layers stacked alternately, and a second doped layer, the second region is provided with a tunnel layer, at least two first doped layers and at least two isolation layers stacked alternately, and a second doped layer, the thickness of the second doped layer on the second region is less than that of the second doped layer on the first region.

In order to achieve the above-mentioned object of the invention, the present invention provides a solar cell. The solar cell includes: a silicon substrate having a first surface and a second surface that are opposite to each other, wherein the second surface of the silicon substrate includes a metal region and a non-metal region; a first electrode located on the first surface of the silicon substrate; and a second electrode located on the second surface of the silicon substrate and disposed in the metal region. A first passivated contact structure is disposed in the metal region. The first passivated contact structure includes a tunnel layer, at least one first doped polysilicon layer, at least one isolation layer, and a second doped polysilicon layer that are sequentially arranged on the second surface.

In an optional embodiment, an orthographic projection of the metal region on the silicon substrate has a size along a plane direction of the substrate greater than or equal to that of an orthographic projection of the second electrode on the silicon substrate.

In an optional embodiment, a second passivated contact structure is disposed in the non-metal region.

In an optional embodiment, the second passivated contact structure comprises a tunnel layer and a first doped polysilicon layer that are sequentially arranged on the second surface.

In an optional embodiment, the second passivated contact structure comprises a tunnel layer, a first doped polysilicon layer, an isolation layer and a second doped polysilicon layer that are sequentially arranged on the second surface.

In an optional embodiment, the second passivated contact structure comprises a tunnel layer and a second doped polysilicon layer that are sequentially arranged on the second surface.

In an optional embodiment, the second passivated contact structure comprises a tunnel layer, at least two first doped polysilicon layers, and at least one isolation layer that are sequentially arranged on the second surface

In an optional embodiment, the second passivated contact structure comprises a tunnel layer, at least two first doped polysilicon layers, at least two isolation layers, and a second doped polysilicon layer that are sequentially arranged on the second surface

In an optional embodiment, the first passivated contact structure and the second passivated contact structure have a height difference therebetween relative to the rear surface of the silicon substrate.

In an optional embodiment, there is a height difference between the first passivated contact structure and the second passivated contact structure relative to the rear surface of the silicon substrate.

Compared to the prior art, the beneficial effects of the present invention are as follows:
In the present invention, the preparation process for the SE (Selective Emitter) structure on the rear side of the cell is simple. By utilizing a laser process, the oxidation of the first region (metallic region) can be achieved, eliminating the need for mask fabrication in the polycrystalline silicon process and the front chain process before removing over-deposited material;
Additionally, in the present invention, the second doped layer in the second region (non-metallic region) on the rear side of the cell is completely or partially removed, while the second doped layer in the first region (metallic region) remains unaffected. Without the need to change the paste, both the passivation effect and the reduction of parasitic absorption can be achieved. This not only expands the process window but also significantly improves the battery efficiency and bifacial rate;
The introduction of a barrier layer on the rear side of the solar cell effectively improves the doping concentration variation in the doped layer during the laser process, preventing damage to the tunnel layer and further enhancing the passivation effect. Moreover, the barrier layer provides a certain resistance to piercing by the backside paste, helping to reduce the total thickness of the rear doped layer and improve the open-circuit voltage (Voc) of the battery.

In other words, in the solar cell of the present invention, the passivation contact structure in the grid line region and the non-grid line region has different film layers and thicknesses. The grid line region features a four-layer structure consisting of a tunnel layer, a first doped polycrystalline silicon layer, a barrier layer, and a second doped polycrystalline silicon layer. This thicker structure with two doped polycrystalline silicon layers prevents the grid line paste from penetrating the doped polycrystalline silicon layer and damaging the underlying tunnel oxide layer during sintering, thereby ensuring field passivation effects. In contrast, the non-grid line region includes only a tunnel layer and a first doped polycrystalline silicon layer, significantly reducing the thickness compared to the grid line region. This reduction in thickness minimizes parasitic absorption of backlight, thereby improving the photoelectric conversion efficiency.

### BRIEF DESCRIPTION OF THE DRAWINGS

Fig. 1 is a schematic structural diagram of the solar cell of the present invention.
Fig. 2 is a flowchart of the preparation method for the passivated contact structure of the solar cell of the present invention.
Fig. 3 is a schematic structural diagram of the solar cell in Embodiment 1 of the present invention.
Fig. 4 is a schematic diagram of partial structure at point A in Fig. 3.
Fig. 5 is a planar schematic diagram of the second surface of the silicon substrate in Embodiment 1 of the present invention.
Fig. 6 is a planar schematic diagram of the second surface and the second electrode in Embodiment 1 of the present invention.
Fig. 7a to Fig. 7j are schematic diagrams of the manufacturing process flow of the solar cell in Embodiment 1 of the present invention.
Fig. 8 is a schematic diagram of the laser scanning pattern in the laser process of Embodiment 1 of the present invention.
Fig. 9 is a schematic structural diagram of the solar cell in Embodiment 2 of the present invention.
Fig. 10 is a schematic diagram of partial structure at point B in Fig. 9.
Fig. 11 is a schematic structural diagram of the solar cell in Embodiment 3 of the present invention.
Fig. 12 is a schematic diagram of the local structure at point C in Fig. 11.
Fig. 13 is a schematic structural diagram of the solar cell in Embodiment 4 of the present invention.
Fig. 14 is a schematic diagram of the local structure at point D in Fig. 13.
Fig. 15 is a schematic diagram of the local structure of the solar cell of the present invention.
Fig. 16 is an SEM image of the pyramid texture on the backlight surface of the present invention.
Fig. 17 is an SEM image of the first region on the backlight surface of the silicon substrate of the present invention.
Fig. 18 is an SEM image of the second region on the backlight surface of the silicon substrate of the present invention.

### DETAILED DESCRIPTION

To make the objectives, technical solutions, and advantages of this application clearer, the following description is provided in detail with reference to the accompanying figures and specific embodiments. However, these embodiments are not intended to limit the present invention. Any structural, methodological, or functional variations made by those skilled in the art based on these embodiments are considered to fall within the scope of protection of the present invention.

It should be noted that, to avoid obscuring the present application with unnecessary details, only the structures and/or processing steps closely related to the solutions of this application are illustrated in the figures, while other details not closely related to this application are omitted. Some dimensions of the structures or local parts in the figures may be exaggerated relative to other structures, solely for the purpose of illustrating the basic structure of the subject matter of the present invention.

Furthermore, it should be understood that the terms 'comprising,' 'including,' or any other variations thereof are intended to cover non-exclusive inclusion, such that a process, method, article, or apparatus that includes a series of elements not only includes those elements explicitly listed but also includes other elements not explicitly listed or elements that are inherent to such a process, method, article, or apparatus.

Additionally, in the present invention, unless otherwise explicitly defined and limited, the first feature being 'on' or 'under' the second feature may indicate that the first and second features are in direct contact, or that they are indirectly in contact through an intermediate medium. Moreover, the first feature being 'above,' 'over,' or 'on top of the second feature may indicate that the first feature is directly above or diagonally above the second feature, or simply that the horizontal height of the first feature is higher than that of the second feature. Similarly, the first feature being 'under,' 'below,' or 'beneath' the second feature may indicate that the first feature is directly below or diagonally below the second feature, or simply that the horizontal height of the first feature is lower than that of the second feature.

The inventors found that in TOPCon solar cells, the doped polysilicon layer on the rear surface thereof, is limited by the paste sintering window and cannot be further thinned. However, a thicker doped polysilicon layer has high parasitic absorption of light, which affects the utilization efficiency of light on the rear surface and thus the cell efficiency. Based on this, the present invention optimizes the passivated contact structure on the rear surface of TOPCon solar cells. It ensures the required thickness in the grid line area to prevent the grid line paste from penetrating the doped polysilicon layer and damaging the underlying tunnel oxide layer during sintering, thereby maintaining field passivation effects; at the same time, the doped polysilicon layer in the non-grid line area is thinned to reduce parasitic absorption of long-wavelength light on the rear surface.

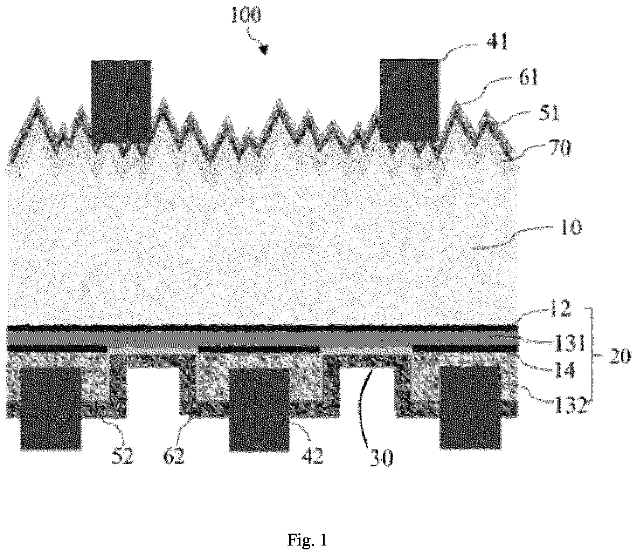

As shown in Figure 1, it is a schematic structure diagram of the solar cell 100 of the present invention. The solar cell is a TOPCon cell, which includes: a silicon substrate 10, a passivated contact structure 20/30 arranged on the rear surface of the silicon substrate 10, electrodes 41/42 respectively arranged on the front and rear surfaces of the silicon substrate 10, passivation layers 51/52, and anti-reflection layers 61/62. The solar cell 100 of the present invention achieves field passivation on the rear surface through the passivated contact structure 20/30, thereby improving the cell efficiency.

As can be understood, the front surface of the silicon substrate 10 is the light-receiving surface, and the rear surface thereof is the backlight surface. The rear surface of the silicon substrate 10 includes a metal region and a non-metal region. The metal region can be the grid line area, and the non-metal region can be the non-grid line area. The electrodes include a front electrode 41 located on the light-receiving surface of the silicon substrate 10 and a back electrode 42 located in the grid line area on the rear surface. The passivation layers and anti-reflection layers respectively include a front passivation layer 51, a rear passivation layer 52, a front anti-reflection layer 61, and a rear anti-reflection layer 62. The structure on the front surface of the silicon substrate 10 may include a front diffusion layer, a front passivation layer 51, and a front anti-reflection layer 61, which are arranged sequentially.

The present invention optimizes the film material and the thickness of the metal region and non-metal region on the rear surface of the silicon substrate 10, while simultaneously improving the backside passivation effect and the utilization efficiency of light. A first passivated contact structure 20 is formed in the metal region, and a second passivated contact structure 30 is formed in the non-metal region.

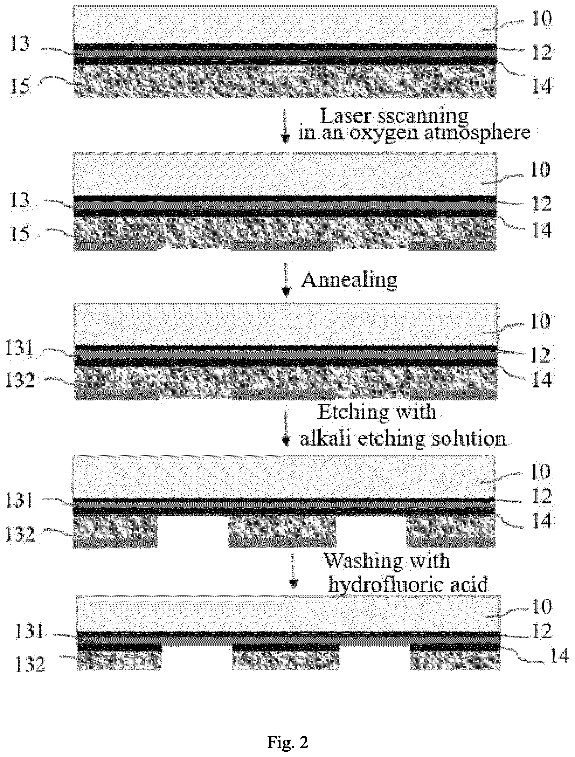

Fig. 2 is a schematic process flowchart for preparing the passivated contact structures 20/30 of the solar cell 100 of the present invention. The preparation method of the passivated contact structure includes the following steps:
S1: sequentially depositing a tunnel layer 12, a first phosphorus-doped amorphous silicon layer 13, an isolation/barrier layer 14, and a second phosphorus-doped amorphous silicon layer 15 on the rear surface of the silicon substrate 10;
S2: scanning the grid line area of the second phosphorus-doped amorphous silicon layer 15 and oxidizing it to form an oxide layer mask. Preferably, the oxide layer is formed by laser treatment in a high-concentration oxygen atmosphere;
S3: performing an annealing process to convert the first phosphorus-doped amorphous silicon layer 13 into a first doped polysilicon layer 131, and the second phosphorus-doped amorphous silicon layer 15 into a second doped polysilicon layer 132;
S4: removing the second doped polysilicon layer 132 in the non-grid line area;
S5: removing the oxide layer mask and the barrier layer 14 to form the first passivated contact structure 20 in the grid line area and the second passivated contact structure 30 in the non-grid line area.

The present invention will be further described in detail below with reference to specific embodiments of the solar cell and its manufacturing method.

### Embodiment 1

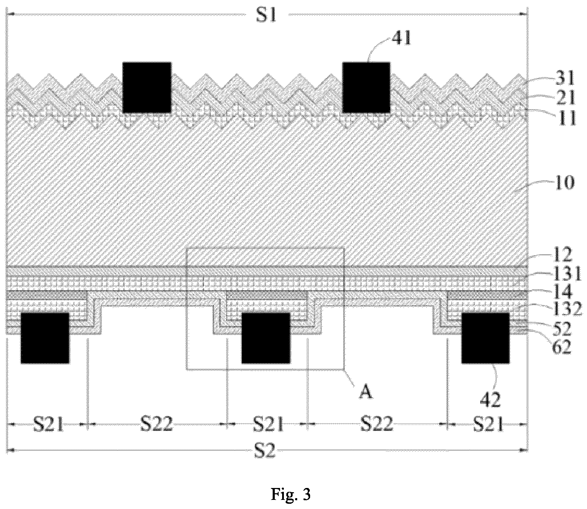

Figs. 3 to 8 illustrate the solar cell and the manufacturing method for the same according to Embodiment 1.

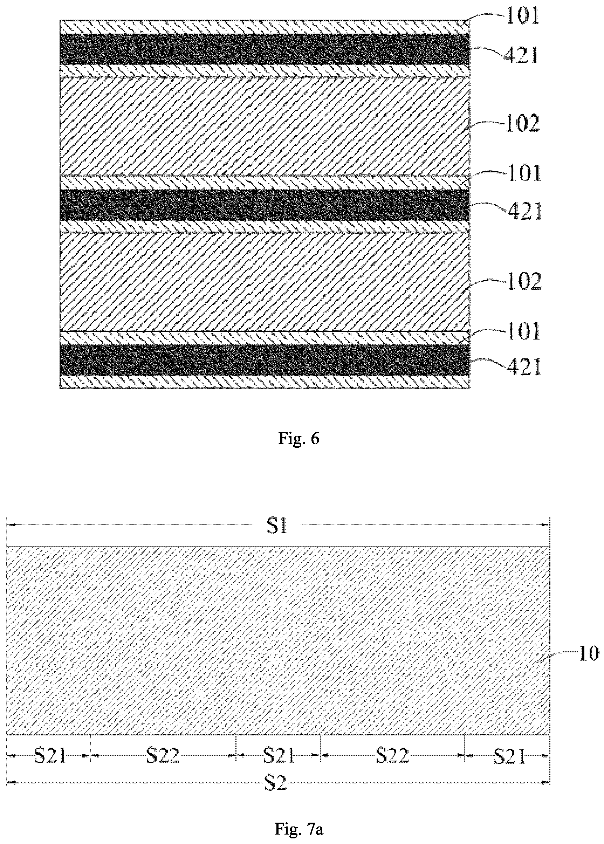

Fig. 3 shows a schematic structural diagram of the solar cell 100 in Embodiment 1. The solar cell is a TOPCon cell and includes a silicon substrate 10. As shown in Fig. 7a, the silicon substrate 10 includes a first surface S1 and a second surface S2 that are oppositely disposed. The second surface S2 includes a first region S21 and a second region S22. The first surface S1 is the front surface (i.e., the light-receiving surface) of the silicon substrate 10, and the second surface S2 is the rear surface (i.e., the backlight surface) of the silicon substrate 10. The first region S21 is the metal region on the rear surface, and the second region S22 is the non-metal region on the rear surface. The rear metal region is the grid line area, and the rear non-metal region is the non-grid line area.

The silicon substrate 10 in Embodiment 1 is an N-type silicon substrate with a resistivity of 0.3 Ω·cm to 7 Ω·cm, preferably 0.5 Ω·cm to 3.5 Ω·cm.

Further, a light-trapping structure is formed on the first surface S1 of the silicon substrate 10. For example, a pyramid texture structure 70 (as shown in Fig. 1) can be formed on the first surface S1 of the silicon substrate 10 through alkali texturing. The pyramid size is 0.5 µm to 3 µm. The texture structure 70 can reduce the front surface reflectance of the solar cell. In other embodiments, the texture structure 70 can adopt a non-pyramid structure.

In Embodiment 1, a front doped layer 11 (i.e., the emitter) is formed on the first surface S1 of the silicon substrate 10 through a diffusion process or a PECVD process. Exemplarily, the front doping layer 11 is a P-type doped layer (i.e., P+ emitter) formed by a boron doping process, with a doping concentration of 3E+18 cm⁻³ to 3E+19 cm⁻³, a sheet resistance of 40 Ω/sq to 300 Ω/sq, and preferably 150 Ω/sq to 250 Ω/sq.

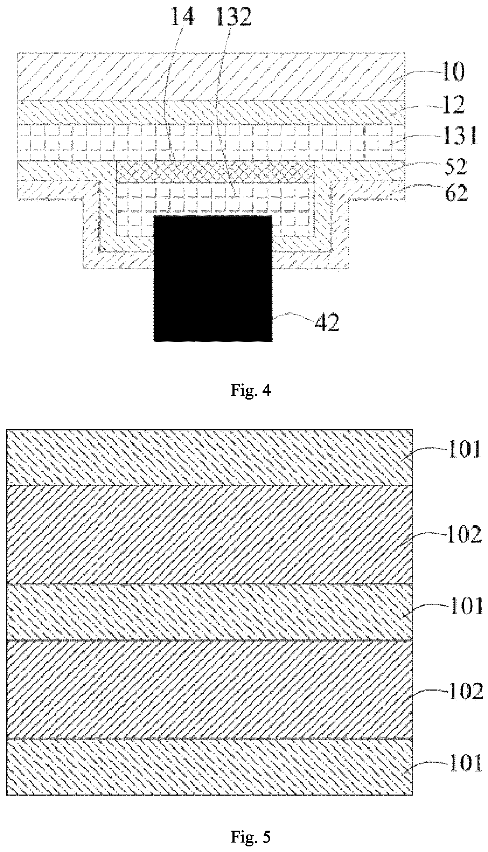

Referring together to Fig. 3 and Fig. 4, in Embodiment 1, the first passivated contact structure 20 is formed on the first region S21 of the second surface S2 of the silicon substrate 10. The first passivated contact structure 20 is composed of a tunnel layer 12, a first doped layer 131, an isolation/barrier layer 14, and a second doped layer 132, which are stacked sequentially. The tunnel layer 12 can be one or a combination of silicon oxide and silicon oxynitride, preferably silicon oxide, with a thickness of 0.5 nm to 3 nm, and more preferably 1.5 nm to 2.5 nm. The isolation/barrier layer 14 can be one or a combination of silicon oxide, silicon carbide, and other materials, with a thickness of 0.5 nm to 3 nm, and more preferably 1.5 nm to 2 nm. In terms of material selection, materials can be chosen based on the requirements of specific applications. For example, silicon carbide can be used in the tunnel layer, or silicon oxynitride can be used in the isolation/barrier layer, etc. These variations are not elaborated here for brevity. For ease of understanding, the barrier layer 14 is referred to in the following embodiments.

In Embodiment 1, a second passivated contact structure 30 is formed on the second region S22 of the second surface S2 of the silicon substrate 10. The second passivated contact structure 30 is composed of a tunnel layer 12 and a first doped layer 131, which are stacked sequentially. It can be understood that the tunnel layer 12 and the first doped layer 131 on the second region S22 are identical to those on the first region S21, and therefore are not further elaborated here.

In the present invention, the doping type of the first doped layer 131 and the second doped layer 132 is the same as the doping type of the silicon substrate, and the surface doping concentration of the second doped layer 132 can be greater than that of the first doped layer 131. At the same time, the thickness of the second doped layer 132 can be greater than that of the first doped layer 131. The total thickness of the first doped layer 131 and the second doped layer 132 is 50 nm to 150 nm, and preferably 60 nm to 100 nm.

Exemplarily, in Embodiment 1, the first doped layer 131 is a phosphorus-doped polysilicon layer with a surface doping concentration of 1E+20 cm ³ to 9E+20 cm⁻³, and more preferably 3E+20 cm ³ to 5E+20 cm⁻³, and a thickness of 1 nm to 100 nm, and more preferably 1 nm to 50 nm. The second doped layer 132 is also a phosphorus-doped polysilicon layer with a surface doping concentration of 2E+20 cm⁻³ to 3E+21 cm⁻³, and more preferably 5E+20 cm ³ to 2E+21 cm⁻³, and a thickness of 1 nm to 100 nm, and more preferably 1 nm to 50 nm.

Preferably, in Embodiment 1, the first surface S1 of the silicon substrate 10 is sequentially stacked with a front passivation layer 51 and a front anti-reflection layer 61, and the second surface S2 of the silicon substrate 10 is sequentially stacked with a rear passivation layer 52 and a rear anti-reflection layer 62. The rear passivation layer 52 and the rear anti-reflection layer 62 cover the second doped layer 132 and extend into the second region S22. Exemplarily, the front passivation layer 51 and the rear passivation layer 52 are both aluminum oxide passivation layers with a thickness of 2 nm to 7 nm, and more preferably 3 nm to 6 nm. The front anti-reflection layer 61 and the rear anti-reflection layer 62 can be a stacked film formed by one or more of silicon nitride, silicon oxynitride, or silicon oxide, with a thickness of 60 nm to 130 nm.

Additionally, in Embodiment 1, the front electrode 41 is located on the first surface S1 of the silicon substrate 10 and is in contact with the front doped layer 11. The back electrode 42 is located on the second surface S2 of the silicon substrate 10, specifically on the first region S21 of the second surface S2, and is in contact with the second doped layer 132.

Referring to Fig. 5, the first region S21 in Embodiment 1 includes multiple first sub-regions 101 that are parallel and evenly spaced. The second region S22 includes multiple second sub-regions 102 that are also parallel and evenly spaced. The first sub-regions 101 and the second sub-regions 102 are staggered. The width of the first sub-region 101 is smaller than that of the second sub-region 102. For example, the width ratio of the first sub-region 101 to the second sub-region 102 can be 1:(5~20). Preferably, the first region S21 occupies approximately 10% of the total area of the second surface S2.

Referring to Fig. 6, the back electrode 42 is a grid line electrode, which includes at least multiple parallel-distributed fine grid lines 421. The width of the first sub-region 101 is greater than or equal to the width of the fine grid lines 421. Optionally, the back electrode 42 may also include multiple main grid lines (not shown) that are perpendicular to the fine grid lines 421.

In this embodiment, taking a 210 TOPCon cell as an example, the dimensions are 203.396±15 mm. The fine grid lines 421 consist of 230 lines, with a width of 15 µm to 100 µm, and the spacing between adjacent fine grid lines is 0.907±0.015 mm. The spacing between adjacent first sub-regions 101 is equal to the spacing between adjacent fine grid lines. Each first sub-region 101 is distributed with one fine grid line 421, and the width of the first sub-region 101 is greater than the width of the fine grid line 421. The width of the first sub-region 101 is 50 µm to 150 µm. For example, if the width of the fine grid line is 40 µm, the width of the first sub-region is 80 µm.

It should be noted that, from the perspective of a front projection plane, when observed along the projection direction opposite to the second electrode 42, the projection width dimension of the metal region on the projection plane is not less than the projection width dimension of the second electrode 42.

The preparation method of the solar cell in this embodiment specifically includes the following steps:

### 1. Double-Sided Texturing

Referring to Fig. 7a, a silicon substrate 10 is provided. The silicon substrate 10 includes a first surface S1 and a second surface S2 that are oppositely disposed. The second surface S2 includes a first region S21 and a second region S22. The first surface S1 is the front surface (i.e., the light-receiving surface) of the silicon substrate 10, and the second surface S2 is the rear surface (i.e., the backlight surface) of the silicon substrate 10. The first region S21 is the grid line area on the rear surface, and the second region S22 is the non-grid line area on the rear surface.

The silicon substrate 10 in this embodiment is an N-type silicon substrate with a resistivity of 0.3 Ω·cm to 7 Ω·cm, preferably 0.5 Ω·cm to 3.5 Ω·cm.

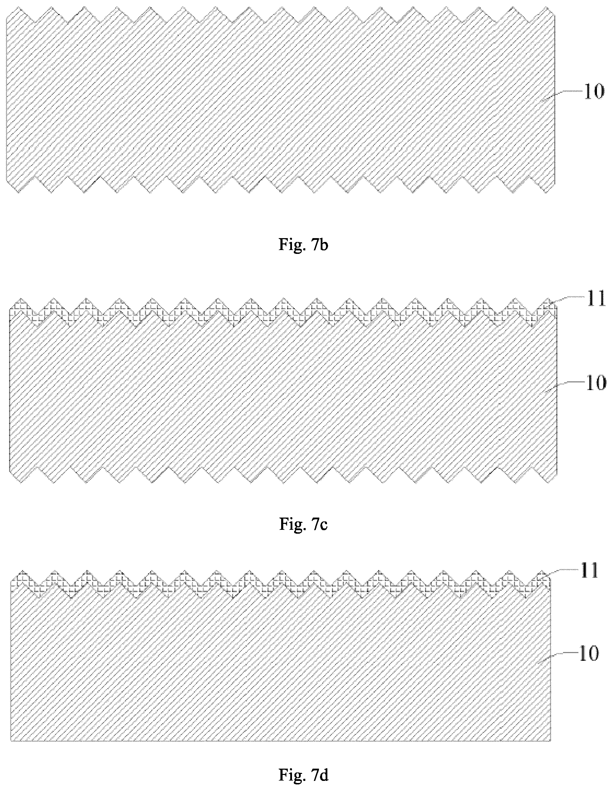

Referring to Fig. 7b, the first surface S1 and the second surface S2 of the silicon substrate 10 in this embodiment are textured with a pyramid texture structure through an alkali texturing process. The pyramid size is 0.5 µm to 3 µm.

### 2. Boron Diffusion

Referring to Fig. 7c, a P-type doped front doped layer (i.e., P+ emitter) 11 is formed on the first surface S1 of the silicon substrate 10 through a boron diffusion process. Specifically, diffusion is carried out in a high-temperature furnace tube using a boron source deposition and drive-in method. After diffusion, the doping concentration of the first doped layer is 3E+18 cm⁻³ to 3E+19 cm⁻³, with a sheet resistance of 40 Ω/sq to 300 Ω/sq, preferably 150 Ω/sq to 250 Ω/sq. During the boron diffusion process, a BSG layer (not shown) is formed on the second surface S2 of the silicon substrate.

### 3. Rear Surface Polishing

Referring to Fig. 7d, after the boron diffusion, the silicon substrate 10 is first processed through a single-sided chain device, where hydrofluoric acid solution is used to remove the silicon dioxide on the rear surface. Then, the rear surface is polished with an alkali solution to remove edge junctions and backside over-deposition (BSG), followed by cleaning.

### 4. Preparation of Rear Surface Tunnel Passivated Contact Structure

Referring to Fig. 7e, a tunnel passivated contact structure is prepared on the second surface S2 by sequentially stacking a tunnel layer 12, a first doped layer 131, a barrier layer 14, and a second doped layer 132.

Exemplarily, in this embodiment, a PECVD process is used to first deposit a silicon dioxide tunnel layer with a thickness of 1 nm to 3 nm. Then, a phosphorus-doped amorphous silicon layer is deposited with a thickness of 1 nm to 100 nm, preferably 1 nm to 50 nm. Next, a silicon dioxide barrier layer is deposited with a thickness of 1 nm to 3 nm, preferably 1.5 nm to 2 nm. Finally, a phosphorus-doped amorphous silicon layer is deposited with a thickness of 1 nm to 50 nm, preferably 50 nm to 100 nm.

### 5. Annealing Activation

The silicon substrate 10 with the deposited tunnel layer 12, first doped layer 131, barrier layer 14, and second doped layer 132 is subjected to an annealing process. Before annealing, both the first doped layer 131 and the second doped layer 132 are phosphorus-doped amorphous silicon layers. The annealing process is used to convert the phosphorus-doped amorphous silicon layers into doped polysilicon layers.

Exemplarily, in this embodiment, the annealing process is carried out in a high-temperature annealing furnace at a temperature of 880°C to 980°C, preferably 900°C to 950°C. After annealing, the doped amorphous silicon is converted into doped polysilicon, and the phosphorus is activated, forming a tunnel passivated contact structure on the rear surface. The surface doping concentration of the first doping layer 131 is 1E+20 cm⁻³ to 9E+20 cm⁻³, preferably 3E+20 cm ³ to 5E+20 cm⁻³ (e.g., 4E+20 cm⁻³). The surface doping concentration of the second doping layer 132 is 2E+20 cm⁻³ to 3E+21 cm⁻³, preferably 5E+20 cm⁻³ to 2E+21 cm⁻³ (e.g., 1E+21 cm⁻³).

### 6. Laser Oxidation

Referring to Fig. 7f, a laser process is used to treat the second doped layer 132 on the first region S21, forming an oxide layer 133 on the surface of the second doped layer in the first region S21.

In the laser oxidation step, silicon dioxide (SiOx) is formed on the surface of the phosphorus-doped amorphous silicon layer in the first region S21 using the instantaneous high temperature of the laser. This silicon dioxide layer serves as a mask for subsequent processes.

Specifically, the laser process is carried out in an oxygen-containing atmosphere with an oxygen volume concentration of 20% to 80%. The laser power is 1 W to 100 W, preferably 30 W to 60 W. The laser frequency is 1 kHz to 1000 kHz, preferably 300 kHz to 600 kHz. The laser scanning speed is 10,000 mm/s to 100,000 mm/s, preferably 30,000 mm/s to 60,000 mm/s. The number of laser processing passes is 1 to 100, preferably 1 to 10. The thickness of the oxide layer 133 formed by the laser process is 1 nm to 50 nm.

Exemplarily, in an embodiment, the oxygen volume concentration in the laser process is 20%, the laser power is 50 W, the laser frequency is 500 kHz, the laser scanning speed is 50,000 mm/s, and the number of laser processing passes is 2.

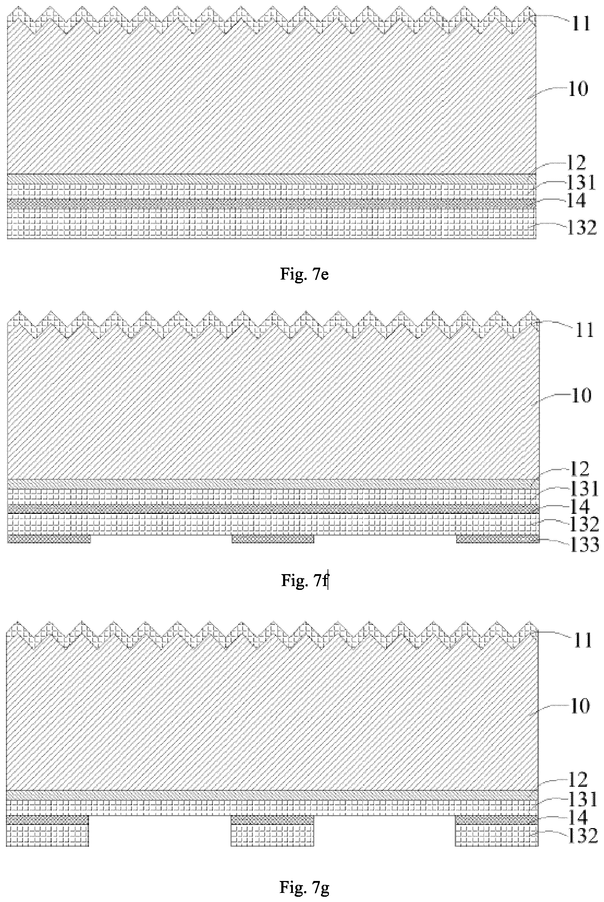

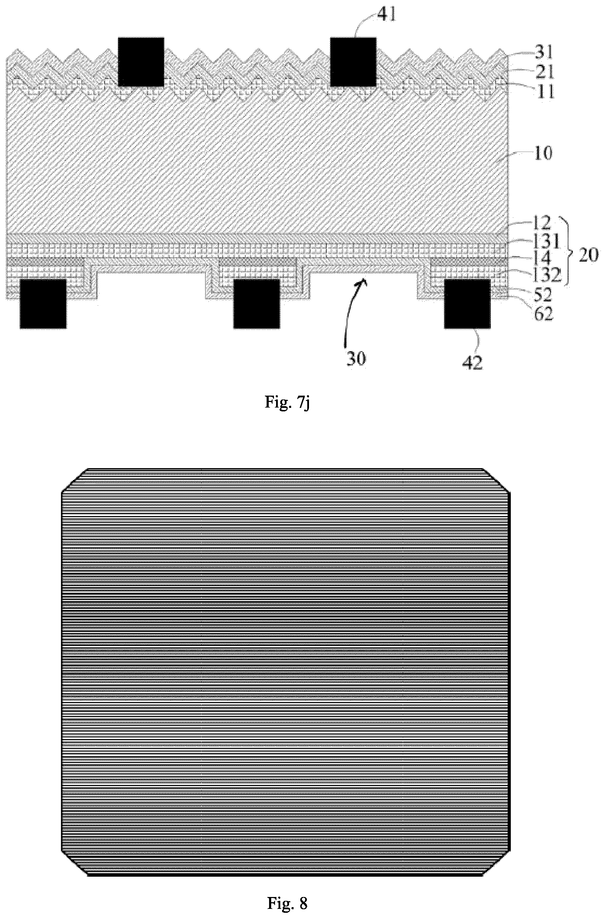

Fig. 8 shows the laser scanning pattern used in the laser process of this embodiment. The black line sections correspond to the laser scanning area, which is the first region S21 (i.e., the metal grid line area), and the blank sections correspond to the second region S22 (i.e., the non-grid line area).

After the laser process, the first region S21 forms a structure consisting of a tunnel layer + phosphorus-doped polysilicon layer + barrier layer + phosphorus-doped polysilicon layer + silicon oxide layer. The second region S22 forms a structure consisting of a tunnel layer + phosphorus-doped polysilicon layer + barrier layer + phosphorus-doped polysilicon layer.

It should be understood that the laser scanning pattern in this invention can be designed according to different electrode structures, thereby forming a patterned silicon oxide mask in the laser scanning area (i.e., the rear metal area). Laser scanning patterns for other electrode structures are not elaborated here for brevity. Additionally, the annealing step and the oxidation step can be adjusted in sequence according to the needs of the actual processing scenario. For example, the mask can be formed first, followed by annealing to convert the phosphorus-doped amorphous silicon layer into a doped polysilicon layer.

In the prior art, a separate mask layer typically needs to be deposited using processes such as PECVD, and the mask must undergo patterning treatment. In contrast, the present invention achieves the preparation of a patterned mask in a single laser process, significantly simplifying the process flow.

During the laser process, high temperatures are generated, which can significantly affect the phosphorus doping amount. Excessive phosphorus can penetrate and damage the tunnel layer, resulting in poor surface passivation and a severely reduced open-circuit voltage of the battery. In the present invention, the introduction of a barrier layer provides a certain degree of resistance to the advancement of phosphorus. By controlling the laser process parameters, the structure can be adapted to different numbers of stacked barrier layers and doped layers.

### 7. Removal of Over-Deposition and Chemical Etching

Referring to Figs. 7f and 7g, a chemical etching process is used to remove all of the second doped layer 132 on the second region S22 and the oxide layer 133 on the first region S21, while retaining the second doped layer 132 on the first region S21. Subsequently, the first passivated contact structure 20 is formed on the first region S21, and the second passivated contact structure 30 is formed on the second region S22.

This step specifically includes:
Alkali Etching: using the oxide layer 133 as a mask, an alkali solution is used to remove the second doped layer 132 on the second region S22, while simultaneously removing edge over-deposition and front-side over-deposition. The mass fraction of the alkali solution is 3% to 5%, and the treatment time is 100 s to 500 s, preferably 350 s.
Acid Cleaning: an acid solution is used to remove the barrier layer 14 on the second region S22 and the oxide layer on the first region S21, while simultaneously removing the PSG on the front side. The mass fraction of the acid solution is 5% to 20%, and the treatment time is 100 s to 500 s, preferably 300 s.

Finally, RCA cleaning is performed. RCA cleaning is a well-known prior art process and is not elaborated here for brevity.

Preferably, in this embodiment, the acid solution is prepared by mixing industrial-grade hydrofluoric acid solution (mass fraction ~40%) with water in a certain ratio, and the alkali solution is prepared by mixing industrial-grade sodium hydroxide solution (mass fraction ~32%) with water in a certain ratio.

In the prior art, an additional front-side chain process (acid cleaning) is typically required before the alkali etching step. This involves passing through a hydrofluoric acid tank to remove the silicon dioxide mask formed by edge over-deposition. However, in the present invention, since the oxide mask is not prepared using a PECVD process, no silicon dioxide over-deposition is formed on the edges. Therefore, the front-side chain process is not necessary.

### 8. Preparation of Passivation Layers

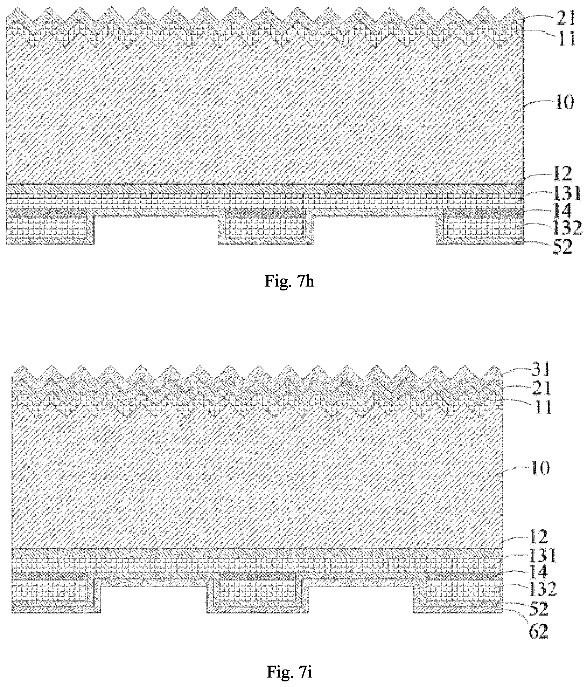

Referring to Fig. 7h, an ALD process is used to prepare a front passivation layer 51 and a rear passivation layer 52 on the first surface S1 and the second surface S2 of the silicon substrate, respectively. Both the front passivation layer 51 and the rear passivation layer 52 are aluminum oxide passivation layers, with a thickness of 2 nm to 7 nm, preferably 3 nm to 6 nm.

### 9. Preparation of Anti-Reflection Layers

Referring to Fig. 7i, a PECVD process is used to prepare a front anti-reflection layer 61 and a rear anti-reflection layer 62 on the first surface S1 and the second surface S2 of the silicon substrate, respectively. The front anti-reflection layer 61 and the rear anti-reflection layer 62 can be a single-layer or multi-layer film formed by any one or more of a silicon nitride layer, a silicon oxynitride layer, or a silicon dioxide layer, with a thickness of 60 nm to 130 nm.

### 10. Printing of Metal Electrodes

Referring to Fig. 7j, the front electrode 41 and the rear electrode 42 are printed on the front and back surfaces, respectively, using a screen printing process. Subsequently, sintering and either light injection or electrical injection treatments are performed to form ohmic contacts.

The front electrode 41 and the rear electrode 42 are grid line electrodes as used in prior art, which typically comprise main grid lines and fine grid lines. It is worth noting that since the fine grid lines of the rear electrode 42 need to be printed on the first region, the width of the first sub-region must be greater than the width of the fine grid lines in the rear electrode 42. In this way, the alignment of the fine grid lines can be achieved.

The TOPCon cell can be fabricated through the above steps. Finally, the cells are tested, sorted, and stored in the warehouse.

### Embodiment 2

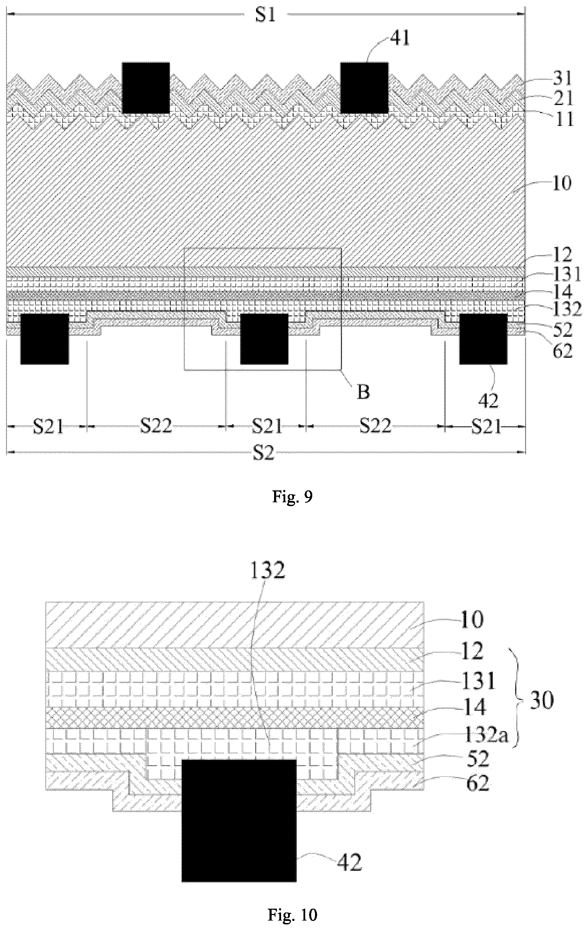

Referring together to Fig. 9 and Fig. 10, the structure of the solar cell 100 in Embodiment 2 is substantially similar to that in Embodiment 1. The difference lies in the following: in Embodiment 2, the second passivation contact structure 30 formed at the second region S22 of the second surface S2 of the silicon substrate 10 consists of a tunnel layer 12, a first doped layer 131, a barrier layer 14, and a second doped layer 132a stacked in sequence. The tunnel layer 12, the first doped layer 131, and the barrier layer 14 of the second passivation contact structure 30 are exactly identical to those in the first passivation contact structure 20 at the first region S21. The difference is that the thickness of the second doped layer 132a in the second passivation contact structure 30 is smaller than the thickness of the second doped layer 132 in the first passivation contact structure 20.

The method for manufacturing the solar cell in this Embodiment 2 is also substantially similar to that in Embodiment 1, with the difference being in Step 7, which involves the removal of over-deposited material and chemical etching. In Embodiment 2, a chemical etching process is used to partially remove the second doped layer 132 on the second region S22 and the oxide layer 133 on the first region S21, while retaining the second doped layer 132 on the first region S21. Additionally, the second doped layer 132 on the second region S22 is thinned to form the second doped layer 132a instead of being completely removed.

This step specifically includes the following processes:
Alkali Etching: using the oxide layer 133 as a mask, an alkali solution is applied to partially remove the second doped layer 132 on the second region S22 (ultimately retaining a portion of the second doping layer as 132a), while simultaneously removing over-deposited material on the front surface and edges. The mass fraction of the alkali solution is 3% to 15%, and the treatment time is less than that in Embodiment 1, such as 50 seconds.
Acid Washing: an acid solution is used to remove the oxide layer 133 on the first region S21, while simultaneously removing the PSG on the front surface. The mass fraction of the acid solution is 5% to 20%, and the treatment time ranges from 100 seconds to 500 seconds, with a preferred duration of 300 seconds.

Finally, RCA cleaning is performed. RCA cleaning is a well-known existing technology and will not be elaborated here.

In Embodiment 2, since a portion of the second doped layer 132a on the second region S22 is retained, the acid solution does not corrode the barrier layer 14 on the second region S22 during the acid washing process. As a result, the barrier layer 14 and a portion of the second doped layer 132a are preserved on the second region.

### Embodiment 3

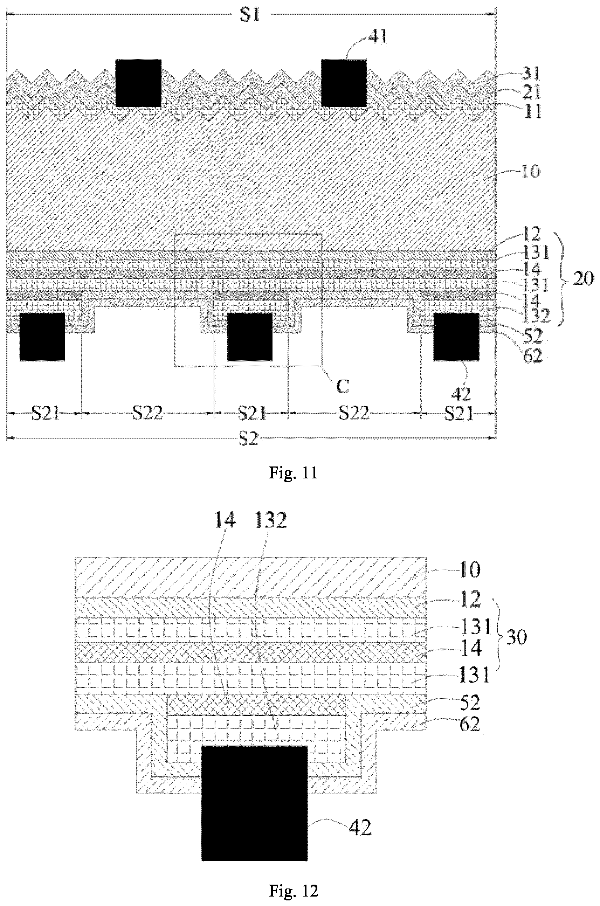

Referring together to Fig. 11 and Fig. 12, the structure of the solar cell 100 in Embodiment 3 is substantially similar to that of the solar cell in Embodiment 1. The difference lies in the following: in Embodiment 3, on the tunnel layer 12 of the second surface S2 of the silicon substrate 10, there are alternately stacked first doped layers 131 and barrier layers 14.

Specifically, on the first region S21 of the second surface S2 of the silicon substrate 10 in Embodiment 3, the tunnel layer 12, the first doped layer 131, the barrier layer 14, the first doped layer 131, the barrier layer 14 and the second doped layer 132 are stacked in sequence. On the second region S22 of the second surface S2 of the silicon substrate 10, the tunnel layer 12, the first doped layer 131, the barrier layer 14 and the first doped layer 131 are stacked in sequence. In other words, in Embodiment 3, the first passivation contact structure 20 consists of six layers, formed by sequentially stacking the tunnel layer 12, the first doped layer 131, the barrier layer 14, the first doped layer 131, the barrier layer 14 and the second doped layer 132. The second passivation contact structure 30 consists of four layers, formed by sequentially stacking the tunnel layer 12, the first doped layer 131, the barrier layer 14 and the first doped layer 131.

The method of manufacturing the solar cell in Embodiment 3 is substantially similar to that in Embodiment 1, with the difference lying in Step 4, which involves the preparation of the rear tunnel passivation structure.

For example, in Embodiment 3, a PECVD process is used to first deposit a silicon dioxide tunnel layer with a thickness of 1 nm to 3 nm on the rear side, and then deposit a phosphorus-doped amorphous silicon layer; then deposit a silicon dioxide barrier layer; then deposit another phosphorus-doped amorphous silicon layer; then deposit a silicon oxide barrier layer; and finally deposit a phosphorus-doped amorphous silicon layer. The total thickness of all phosphorus-doped amorphous silicon layers is controlled to be 50 nm to 150 nm, preferably 60 nm to 100 nm, and the thickness of the outermost phosphorus-doped amorphous silicon layer is preferably 50 nm to 100 nm.

Correspondingly, in Step 7 of Embodiment 3, which involves the removal of over-deposited material and chemical etching, the alkali etching is used to remove the second doped layer 132 on the second region S22, while the acid solution is used to remove the outermost barrier layer 14 on the second region S22 and the oxide layer 133 on the first region S21.

### Embodiment 4

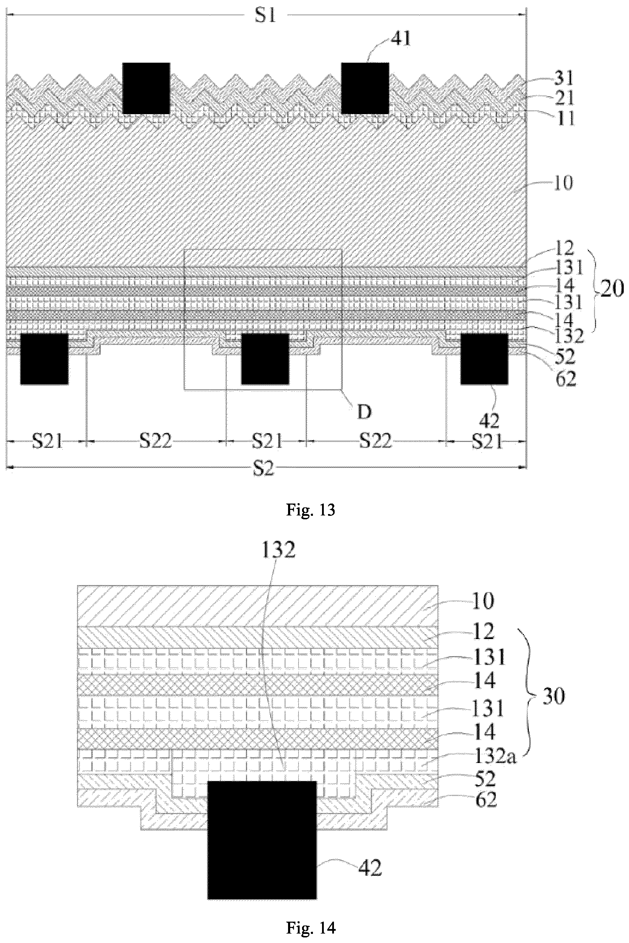

Referring together to Fig. 13 and Fig. 14, the solar cell in Embodiment 4 is substantially similar to the solar cell in Embodiment 3. The difference lies in the following: in Embodiment 4, the second passivation contact structure 30 on the second region S22 of the second surface S2 of the silicon substrate 10 is composed of layers stacked in the following order: a tunnel layer 12, a first doped layer 131, a barrier layer 14, a first doped layer 131, a barrier layer 14, and a second doped layer 132a. The thickness of the second doped layer 132a is smaller than that of the second doped layer 132 in the first passivation contact structure 20. In other words, in Embodiment 4, both the first passivation contact structure 20 and the second passivation contact structure 30 consist of six layers.

The method for manufacturing the solar cell in Embodiment 4 is substantially similar to that in Embodiment 3, with the difference lying in Step 7, which involves the removal of over-deposited material and chemical etching. In Embodiment 4, a chemical etching process is used to partially remove the second doped layer 132 on the second region S22 and the oxide layer 133 on the first region S21, while retaining the second doped layer 132 on the first region S21. The second doped layer 132 on the second region S22 is thinned to form the second doped layer 132a, rather than being completely removed.

In Embodiment 4, since a portion of the second doped layer 132a on the second region S22 is retained, the acid solution does not corrode the outermost barrier layer 14 on the second region S22 during the acid washing process. As a result, the outermost barrier layer 14 and a portion of the second doped layer 132a are preserved on the second region S22.

### Embodiment 5

The solar cell and corresponding manufacturing method in Embodiment 5 are substantially similar to those in Embodiment 1, with the difference lying in the preparation of the front doped layer 11. In Embodiment 1, the front doped layer 11 is prepared using a boron diffusion process, whereas in Embodiment 5, the front doped layer 11 is prepared using a PECVD process.

Specifically, in the present embodiment, a PECVD process is used to first deposit a boron-doped amorphous silicon layer on the first surface S1, which is then subjected to high-temperature oxidation annealing to form a P-type doped polycrystalline silicon layer.

It should be understood that in Embodiment 3 and Embodiment 4, two layers of the second doped layer and two layers of the barrier layer are used as an example for illustration. In other embodiments, three or more layers of the second doped layer and barrier layer can also be arranged. Any technical solution that removes all or part of the third doped layer on the second region S22 through alkali etching falls within the scope of protection of the present invention, and further embodiments are not elaborated here.

In summary, the solar cell 100 described in Embodiments 1-5 includes a first passivation contact structure 20 located in the first region S21, which consists of a tunnel layer 12, at least one first doped layer 131, at least one barrier layer 14, and a second doped layer 132. The electrode 42 is in contact with the second doped layer 132. Between the tunnel layer 12 and the second doped layer 132, the first doped layer 131 and the barrier layer 14 can be alternately arranged as needed for specific application scenarios. It can be understood that on the rea side of the second doped layer 132, a rear passivation layer 52 and a rear anti-reflection layer 62 are also formed.

Similarly, the second passivation contact structure 30 located in the second region S22 includes a tunnel layer 12 and a first doped layer 131. In some design scenarios, the second passivation contact structure 30 can further include a barrier layer 14 and a first doped layer 131 on the rear side of the first doped layer 131. In other design scenarios, the second passivation contact structure 30 can further include a barrier layer 14 and a second doped layer 132a on the rear side of the first doped layer 131. Between the tunnel layer 12 and the second doped layer 132a, the first doped layer 131 and the barrier layer 14 can also be alternately arranged. Furthermore, the second doped layer 132a in the second passivation contact structure 30 is the same doped layer as the second doped layer 132 in the first passivation contact structure 20, but their thicknesses differ from each other. Additionally, the rear passivation layer 52 and the rear anti-reflection layer 62 are also formed on the rear side of the outermost first doped layer 131 or the second doped layer 132a in the second passivation contact structure 30.

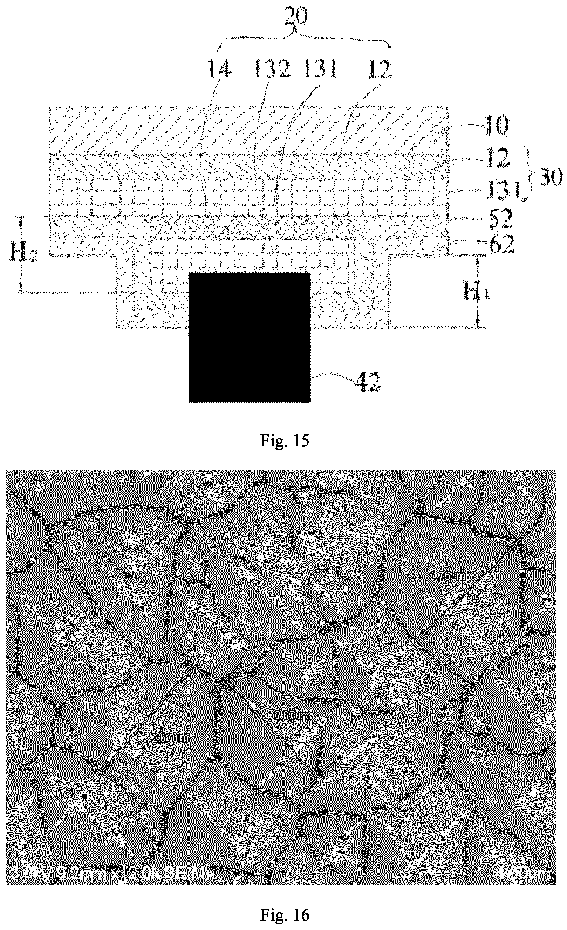

Referring to Fig. 15, in the present invention, a height difference H1/H2 is formed between the first passivation contact structure 20 and the second passivation contact structure 30. The numeral H1 represents the height difference formed between the outer side of the rear anti-reflection layer 62 in the first region S21 and the outer side of the rear anti-reflection layer 62 in the second region S22. The numeral H2 represents the height difference formed along the thickness direction of the silicon substrate 10 between the outermost surface of the first passivation contact structure 20 and the outermost surface of the second passivation contact structure 30.

In the present invention, depending on the number of layers and the composition selected for the first passivation contact structure 20 and the second passivation contact structure 30, the value of the height difference H1/H2 is either equal to the thickness difference between the second doped layer 132 and the second doped layer 132a, or equal to the sum of the thickness of the barrier layer 14 and the second doped layer 132. For example:

In Embodiment 1, the first passivation contact structure 20 consists of four layers, and the second passivation contact structure 30 consists of two layers. In this case, the height difference H1/H2 between the two structures is equal to the sum of the thickness of the barrier layer 14 and the second doped layer 132.

In Embodiment 2, the first passivation contact structure 20 consists of four layers, and the second passivation contact structure 30 also consists of four layers. In this case, the height difference H1/H2 between the two structures is equal to the thickness difference between the second doped layer 132 and the second doped layer 132a.

In Embodiment 3, the first passivation contact structure 20 consists of six layers, and the second passivation contact structure 30 consists of four layers. In this case, the height difference H1/H2 between the two structures is equal to the sum of the thickness of the barrier layer 14 and the second doped layer 132.

In Embodiment 4, the first passivation contact structure 20 consists of six layers, and the second passivation contact structure 30 also consists of six layers. In this case, the height difference H1/H2 between the two structures is equal to the thickness difference between the second doped layer 132 and the second doped layer 132a.

It can be understood that when the thickness of the rear passivation layer 52 in the first region S21 and the second region S22 is inconsistent, and/or the thickness of the rear anti-reflection layer 62 in the first region S21 and the second region S22 is inconsistent, the height difference H1/H2 formed between the first and second passivation contact structures 20 and 30 also includes the thickness variation difference of the rear passivation layer/rear anti-reflection layer 52 and 62. Further examples are not elaborated here.

In the present invention, the preferred value range for the height difference H1/H2 is 0.01 µm to 8 µm.

Referring to Figs 16 to 18, in the present invention, the size range of the pyramid texture structure 70 is 0.5 µm to 3 µm. Figure 16 shows an SEM image of the pyramid-textured pyramidal structure 70 in the present invention, where the sizes of the three pyramids indicated are 2.67 µm, 2.60 µm, and 2.75 µm, respectively, with an average size of approximately 2.7 µm. Both the first region S21 and the second region S22 of the second surface S2 are polished surfaces after polishing the pyramid-textured pyramidal structure. In this structure, the silicon substrate 10 is recessed in the second region S22, and the base size of the pyramids on the first region S21 is smaller than that on the second region S22. During the alkali polishing process, the pyramid-textured pyramidal structure on the rear side of the silicon substrate is polished to form bases which refer to the pedestal left after polishing the pyramid-shaped pyramidal texture. The shape of the base can be triangular, quadrilateral, or other shapes. The base size is defined as the average width of the base shape. For a square base, the base size is the average of the side lengths of the square. The base size formed during the alkali polishing process is larger than the pyramid size, and the deeper the etching depth, the larger the base size. In the present invention, the base size on the first region S21 ranges from 3 µm to 20 µm, preferably 8 µm to 15 µm, while the base size on the second region S22 ranges from 3 µm to 50 µm, preferably 15 µm to 30 µm.

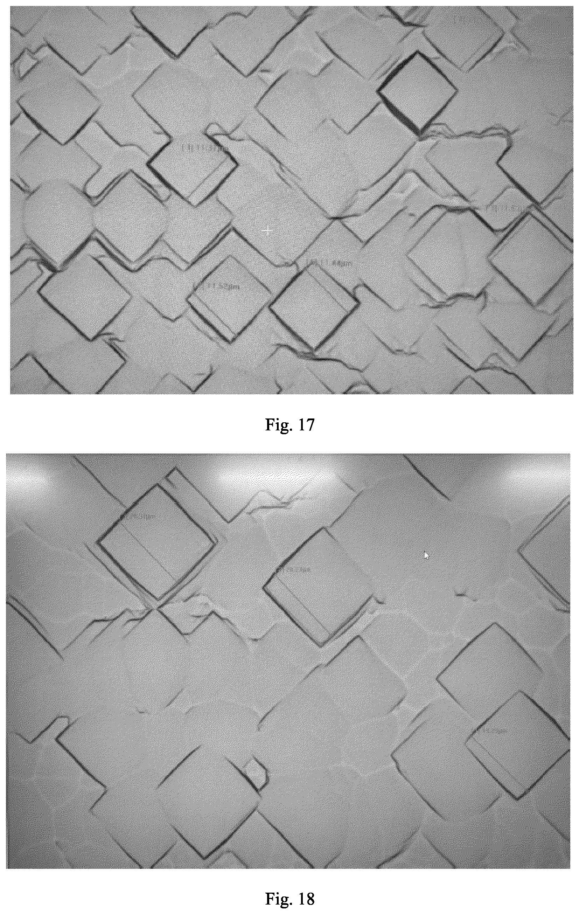

Figure 17 shows an SEM image of the first region S21, where the indicated base sizes are 11.37 µm, 11.52 µm, 11.44 µm, 11.53 µm, and 11.13 µm, respectively. The average base size on the first region S21 is approximately 11.4 µm. Figure 18 shows an SEM image of the second region S22, where the etching depth is deeper, resulting in larger base sizes. The indicated base sizes in the second region S22 are 20.30 µm, 20.23 µm, and 19.29 µm, respectively, with an average base size of approximately 20 µm.

In the present invention, the preparation process for the SE (Selective Emitter) structure on the rear side of the cell is simple. By utilizing a laser process, the oxidation of the first region (metallic region) can be achieved, eliminating the need for mask fabrication in the polycrystalline silicon process and the front chain process before removing over-deposited material.

Additionally, in the present invention, the second doped layer in the second region (non-metallic region) on the rear side of the cell is completely or partially removed, while the second doped layer in the first region (metallic region) remains unaffected. Without the need to change the paste, both the passivation effect and the reduction of parasitic absorption can be achieved. This not only expands the process window but also significantly improves the battery efficiency and bifacial rate.

The introduction of a barrier layer on the rear side of the solar cell effectively improves the doping concentration variation in the doped layer during the laser process, preventing damage to the tunnel layer and further enhancing the passivation effect. Moreover, the barrier layer provides a certain resistance to piercing by the backside paste, helping to reduce the total thickness of the rear doped layer and improve the open-circuit voltage (Voc) of the battery.

It is to be understood, however, that even though numerous characteristics and advantages of preferred and exemplary embodiments have been set out in the foregoing description, together with details of the structures and functions of the embodiments, the disclosure is illustrative only; and that changes may be made in detail within the principles of present disclosure to the full extent indicated by the broadest general meaning of the terms in which the appended claims are expressed.

## Claims

1. A solar cell, comprising:
a silicon substrate having a front surface and a rear surface;
a passivated contact structure located on the rear surface of the silicon substrate; and
a rear electrode located on the passivated contact structure,
wherein the passivated contact structure comprises a tunnel layer, a first doped polysilicon layer, an isolation layer, and a second doped polysilicon layer that are sequentially arranged on the rear surface of the silicon substrate, wherein the isolation layer is configured in a non-continuous arrangement.

2. The solar cell according to claim 1, wherein the isolation layer comprises one or more of a silicon oxide layer, a silicon oxynitride layer, and a silicon carbide layer.

3. The solar cell according to claim 1, wherein:
a thickness of the tunnel layer ranges from 1 nm to 3 nm, and preferably, from 1.5 nm to 2 nm; and/or
a thickness of the isolation layer ranges from 0.5 nm to 3 nm, and preferably, from 1.5 nm to 2 nm.

4. The solar cell according to claim 1, wherein a thickness of the first doped polysilicon layer is less than or equal to a thickness of the second doped polysilicon layer.

5. The solar cell according to claim 1, wherein:
doping types of the first doped polysilicon layer and the second doped polysilicon layer are the same as that of the silicon substrate, and a doping concentration of the second doped polysilicon layer is greater than a doping concentration of the first doped polysilicon layer; or
the doping concentration of the first doped polysilicon layer is in the range of 1×10²⁰ cm⁻³ to 9×10²⁰ cm⁻³, and the doping concentration of the second doped polysilicon layer is in the range of 2×10²⁰ cm⁻³ to 3×10²¹ cm⁻³.

6. The solar cell according to claim 1, wherein the solar cell further comprises:
a rear passivation layer and a rear anti-reflection layer that are sequentially arranged on a surface of the passivated contact structure facing away from the rear surface of the silicon substrate, and a front diffusion layer, wherein the rear electrode penetrates the rear anti-reflection layer and the rear passivation layer to contact the second doped polysilicon layer; and
a front passivation layer, a front anti-reflection layer, a front electrode that are sequentially arranged on the front surface of the silicon substrate, wherein the front electrode penetrates the front anti-reflection layer and the front passivation layer to contact the front diffusion layer.

7. A method for manufacturing a solar cell, comprising:
depositing a tunnel layer, a first doped amorphous silicon layer, an isolation layer, and a second doped amorphous silicon layer sequentially on a rear surface of a silicon substrate;
forming a mask locally on the second doped amorphous silicon layer, wherein the mask layer is preferably formed by laser processing in an oxygen atmosphere;
converting the first doped amorphous silicon layer to a first doped polysilicon layer and the second doped amorphous silicon layer to a second doped polysilicon layer;
removing the second doped polysilicon layer in the regions outside the mask; and
removing the mask and part of the isolation layer to form a discontinuous isolation layer.

8. A method for manufacturing a solar cell, comprising:
providing a silicon substrate, the silicon substrate having a first surface and a second surface that are opposite to each other, the second surface comprising a first region and a second region;
preparing a tunnel layer, a first phosphorus-doped amorphous silicon layer, an isolation layer, and a second phosphorus-doped amorphous silicon layer sequentially on the second surface of the silicon substrate;
converting the first phosphorous-doped amorphous silicon layer to a first doped polysilicon layer and the second phosphorous-doped amorphous silicon layer to a second doped polysilicon layer;
forming a mask layer on the surface of the second doped amorphous silicon layer in the first region;
removing at least part of the second doped polysilicon layer in the second region and the mask layer in the first region, to retain the second doped polysilicon in the first region; and
preparing an electrode in contact with the second doped polysilicon layer in the first region.

9. The method according to claim 8, wherein the mask layer is an oxide layer, and
wherein said removing at least part of the second doped polysilicon layer in the second region and the mask layer in the first region, to retain the second doped polysilicon in the first region comprises:
removing the entire second doped polysilicon layer on the second region using an alkaline solution, and removing the outermost isolation layer on the second region and the oxide layer on the first region; or
removing part of the second doped polysilicon layer on the second region using an alkaline solution, and removing the oxide layer on the first region using an acid solution.

10. A solar cell, comprising:
a silicon substrate having a first surface and a second surface that are opposite to each other, the second surface comprising a first region and a second region, wherein a tunnel layer, at least one first doped layer, at least one isolation layer and a second doped layer are arranged on the second surface in the first region, and wherein a tunnel layer and at least one first doped layer are arranged on the second surface in the second region; and
an electrode located in the first region and in contact with the second doped layer.

11. The method according to claim 10, wherein:
the first region is provided with a tunnel layer, one first doped layer, one isolation layer, and a second doped layer, the second region is provided with a tunnel layer and one first doped layer; or
the first region is provided with a tunnel layer, one first doped layer, one isolation layer, and a second doped layer, the second region is provided with a tunnel layer, one first doped layer, one isolation layer, and a second doped layer, a thickness of the second doped layer on the second region is less than that of the second doped layer on the first region; or
the first region is provided with a tunnel layer, at least two first doped layers, at least two isolation layers stacked alternately, and a second doped layer, the second region is provided with a tunnel layer, at least two first doped layers and at least one isolation layer stacked alternately; or
the first region is provided with a tunnel layer, at least two first doped layers and at least two isolation layers stacked alternately, and a second doped layer, the second region is provided with a tunnel layer, at least two first doped layers and at least two isolation layers stacked alternately, and a second doped layer, the thickness of the second doped layer on the second region is less than that of the second doped layer on the first region.

12. A solar cell, comprising:
a silicon substrate having a first surface and a second surface that are opposite to each other, wherein the second surface of the silicon substrate comprises a metal region and a non-metal region;
a first electrode located on the first surface of the silicon substrate; and
a second electrode located on the second surface of the silicon substrate and disposed in the metal region,
wherein a first passivated contact structure is disposed in the metal region, the first passivated contact structure comprising a tunnel layer, at least one first doped polysilicon layer, at least one isolation layer, and a second doped polysilicon layer that are sequentially arranged on the second surface.

13. The method according to claim 12, wherein an orthographic projection of the metal region on the silicon substrate has a size along a plane direction of the substrate greater than or equal to that of an orthographic projection of the second electrode on the silicon substrate.

14. The solar cell according to claim 12, wherein a second passivated contact structure is disposed in the non-metal region, wherein:
the second passivated contact structure comprises a tunnel layer and a first doped polysilicon layer that are sequentially arranged on the second surface; or
the second passivated contact structure comprises a tunnel layer, a first doped polysilicon layer, an isolation layer and a second doped polysilicon layer that are sequentially arranged on the second surface; or
the second passivated contact structure comprises a tunnel layer and a second doped polysilicon layer that are sequentially arranged on the second surface; or
the second passivated contact structure comprises a tunnel layer, at least two first doped polysilicon layers, and at least one isolation layer that are sequentially arranged on the second surface; or
the second passivated contact structure comprises a tunnel layer, at least two first doped polysilicon layers, at least two isolation layers, and a second doped polysilicon layer that are sequentially arranged on the second surface.

15. The solar cell according to claim 13, wherein the first passivated contact structure and the second passivated contact structure have a height difference therebetween relative to the rear surface of the silicon substrate.
